(19) Europäisches Patentamt
European Patent Office
Office européen des brevets

(11) **EP 4 764 819 A1**

(12) **EUROPEAN PATENT APPLICATION**

(43) Date of publication:
**24.06.2026 Bulletin 2026/26**

(21) Application number: **24307179.2**

(22) Date of filing: **19.12.2024**

(51) International Patent Classification (IPC):
**G06F 7/483** (2006.01)    **H03M 7/24** (2006.01)

(52) Cooperative Patent Classification (CPC):
**G06F 7/483; H03M 7/24**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(71) Applicant: **BULL SAS**
**78340 Les Clayes-Sous-Bois (FR)**

(72) Inventors:
- **GAZDA, Arnaud**
  **78000 VERSAILLES (FR)**
- **CHEAH, Stanley**
  **78370 PLAISIR (FR)**
- **JAURE, Stephan**
  **38190 BERNIN (FR)**
- **RISCHETTE, Romain**
  **26000 VALENCE (FR)**

(74) Representative: **Plasseraud IP**
**104 Rue de Richelieu**
**CS92104**
**75080 Paris Cedex 02 (FR)**

(54) **METHODS FOR DATA COMMUNICATION AND APPARATUSES FOR IMPLEMENTING THE SAME**

(57)    A method for transmitting a first number to a recipient computing machine in a distributed computing environment is proposed, which comprises: obtaining a second number corresponding to the first number, wherein the first number belongs to a first range of numbers, and the second number belongs to a second range of numbers; determining an encoding of the second number according to a binary format for encoding floating-point numbers, wherein a binary code representing a number encoded according to the format comprises a sign binary field carrying at most one sign bits encoding a sign of the number, an exponent binary field carrying one or more exponent bits encoding an exponent of a power of 2, and a fraction binary field carrying one or more significant decimal digits and transmitting, to the recipient computing machine, data representing the first number, wherein the data carries an encoding of the second number according to the format with no exponent field corresponding to the encoded second number.

FIG. 4a

## Description

The present subject disclosure relates to the field of data communication between two computing machines in a distributed computing environment, in particular to the data communication between two processors in a distributed processing environment.

Quantum Computing is a field of computer science designed to solve some advanced problems faster than a classical computer, by using quantum mechanics. In this context, the term "classical" is often used to refer to a computer, a computing environment, a computing device (e.g. a processor) or a computing field which, as opposed to a reference to the term "quantum", does not use quantum mechanics.

The emerging field of Quantum Computing will have a significant impact in High Performance Computing (HPC), as HPC is already reaching the limit of classical computing. Consequently, HPC centers that only use classical computing may evolve to integrate quantum devices such as one or more Quantum Processing Units (QPUs) in the near future, to prepare for this new quantum revolution.

Hybrid computing environments that include both classical processing resources and quantum processing resources are therefore being considered for execution of hybrid computing jobs which comprise one or more quantum computing parts and one or more non-quantum computing parts, with the quantum computing resource(s) being viewed as expensive resources as compared to non-quantum processing resources.

Quantum circuit simulations are essential for evaluating quantum algorithms and real quantum processing units (QPUs). However, the number of state amplitudes required for a full simulation increases exponentially with the number of qubits, posing a significant scalability challenge even for the most powerful supercomputers. To simulate circuits with a larger number of qubits, resource distribution becomes crucial, particularly in a high-performance computing (HPC) cluster. Although several optimization techniques have been proposed to reduce simulation time, they are generally designed for single-node simulations.

There is therefore a need for an improved method for data transmission between two computing machines that addresses the drawbacks and shortcomings of the conventional technology in the art, including in the specific context of distributed quantum circuit simulations.

In particular, it is an object of the present subject disclosure to provide an improved method for data communication between two computing machines in a distributed computing environment that addresses the drawbacks and shortcomings of the conventional technology in the art.

Another object of the present subject disclosure is to provide an improved method for data transmission between nodes involved in distributed quantum circuit simulations that addresses the drawbacks and shortcomings of the conventional technology in the art.

Yet another object of the present subject disclosure is to provide an improved method for inter-processor data communication in a distributed computing environment.

To achieve these objects and other advantages and in accordance with the purpose of the present subject disclosure, as embodied and broadly described herein, in one aspect of the present subject disclosure, a method for transmitting (data representing) a first (real) number to a recipient computing machine in a distributed computing environment is proposed. The proposed method may comprise, by a sender computing machine in the distributed computing environment: obtaining a second (real) number $\tilde{r}$ corresponding to the first (real) number, wherein the first (real) number belongs to a first range of numbers, and the second (real) number belongs to a second range of numbers; determining an encoding of the second (real) number according to a binary format for encoding floating-point numbers, wherein a binary code representing a number encoded according to the format comprises a sign binary field carrying at most one sign bits encoding a sign of the number, an exponent binary field carrying one or more exponent bits encoding an exponent of a power of 2, and a fraction binary field carrying one or more significant decimal digits; and transmitting, to the recipient computing machine, data representing the first (real) number, wherein the data carries an encoding of the second (real) number according to the format with no exponent field corresponding to the encoded second (real) number.

Advantageously, the present subject disclosure provides methods that reduce the amount of data (in particular data representing (real) numbers) exchanged between computing nodes involved in distributed computing (e.g. in distributed quantum circuit simulations), thereby decreasing the data transmission time (time used for (duration of) data transmission) and the overall (distributed) processing (e.g. quantum circuit simulation processing) time.

**In** one or more embodiments, the proposed method may further comprise: transmitting, to the recipient computing machine, one or more of data representing the first range of numbers, and data representing the second range of numbers.

Depending on the embodiments, one or more of the data representing the first range of numbers, and the data representing the second range of numbers may be preconfigured at the recipient computing machine.

**In** one or more embodiments, the data representing the first range of numbers may comprise data based on which the first range of numbers can be determined. In one or more embodiments, the data representing the second range of numbers may comprise data based on which the second range of numbers can be determined. For example, in some embodiments, the proposed method may further comprise: transmitting, to the recipient computing machine one or more of data representing a lower bound value *a* of the first range of numbers, and data representing an upper bound value *b* of the first range of numbers.

In some embodiments, the proposed method may further comprise: transmitting, to the recipient computing machine, one or more of data representing a (e.g. lower, upper) bound value of the first range of numbers, and data representing a range of the first range of numbers. In some embodiments, the proposed method may further comprise: transmitting, to the recipient computing machine, one or more of data representing a lower bound value of the second range of numbers, and data representing an upper bound value of the second range of numbers. In some embodiments, the proposed method may further comprise: transmitting, to the recipient computing machine, one or more of data representing a (e.g. lower, upper) bound value of the second range of numbers, and data representing a range of the second range of numbers.

In some embodiments, the second range of numbers may be of the type (expressible as) $[2^i, 2^{i+1}[$ wherein $i$ is a natural integer, and the proposed method may further comprise: transmitting, to the recipient computing machine, data related to the power $i$. In some embodiments, the second range of numbers may be of the type (expressible as) $[2^i, 2^{i+1} - \varepsilon]$, wherein $i$ is a natural integer, and $0 < \varepsilon < 2^{i+1} - 2^i$, and the proposed method may further comprise: transmitting, to the recipient computing machine, data related to one or more of the power i and the number $\varepsilon$.

In some embodiments, the recipient computing machine may be configured for using a second range of numbers of the type (expressible as) $[2^i, 2^{i+1}[$ wherein i is a natural integer (which may be expressed in some embodiments as the type (expressible as) $[2^i, 2^{i+1} - \varepsilon]$, wherein $i$ is a natural integer, and $0 < \varepsilon < 2^{i+1} - 2^i$), and the recipient computing machine may obtain data based on which the value of the natural integer i can be determined.

In one or more embodiments, the second number $\tilde{r}$ may be determined by transforming the first number $r$ using a function that transforms the interval $[a,b]$ (first range of numbers) into the interval $[2^i, 2^{i+1}[$ (second range of numbers), where $i$ is a natural integer (*a* being a lower bound value of the first range of numbers, and b being an upper bound value of the first range of numbers, such that $a < b$). In some embodiments, the function may be defined (for example configured at the sender computing machine) to project the first range of numbers (for example an interval $[a,b]$) onto the second range of numbers (for example an interval of the type (expressible as) $[2^i, 2^{i+1}[$ [or, depending on the embodiment, of the type (expressible as) $[2^i, 2^{i+1} - \varepsilon]$, where $0 < \varepsilon < 2^{i+1} - 2^i$).

In one or more embodiments, the second number $\tilde{r}$ may be determined by transforming the first number r using the following function *f:*

$$\tilde{r} := f(r) = \frac{1-\varepsilon}{b-a}r + \left(1 - \frac{1-\varepsilon}{b-a}a\right)$$

where $0 < \varepsilon < 1$, *a* is a lower bound value of the first range of numbers, b is an upper bound value of the first range of numbers, such that $a < b$. In such embodiments, the second range of numbers may be an interval of the type (expressible as) $[1, 2 - \varepsilon]$.

In one or more embodiments, the second number $\tilde{r}$ may be determined by transforming the first number r using the following function *f:*

$$\tilde{r} := f(r) = \frac{2^i-\varepsilon}{b-a}r + \left(2^i - \frac{2^i-\varepsilon}{b-a}a\right)$$

where $\varepsilon$ is a real number such that $0 < \varepsilon < 2^{i+1} - 2^i$, *a* is a lower bound value of the first range of numbers, b is an upper bound value of the first range of numbers, such that $a < b$, and i is a natural integer. In some embodiments, the second range of numbers may be an interval of the type (expressible as) $[2^i, 2^{i+1} - \varepsilon]$.

According to another aspect of the present subject disclosure, a method for receiving data representing a first number from a first computing machine in a distributed computing environment is proposed. The proposed method comprises, by a second computing machine in the distributed computing environment: receiving, from the sender computing machine, data representing the first number, wherein the data carries an encoding of a second number according to a format with no exponent field corresponding to the encoded second number, wherein a binary code representing a number encoded according to the format comprises a sign binary field carrying zero or one sign bit encoding a sign of the number, an exponent binary field carrying one or more exponent bits encoding an exponent of a power of 2, and a fraction binary field carrying one or more significant decimal digits; generating, based on the received data, a binary code corresponding to the second number encoded according to the format, the binary code corresponding to the encoded second number comprising a respective exponent binary field, a respective sign binary field, and a respective fraction binary field; and determining, based on the binary code corresponding to the encoded second number, the first number.

In one or more embodiments, the first number may belong to a first range of numbers, and the second number may belong to a second range of numbers, which may be different from the first range of numbers.

In one or more embodiments, the second number may belong to a second range of numbers, and the method may further comprise: receiving, from the sender computing machine, data representing the first range of numbers. In one or more embodiments, the first number may belong to a first range of numbers, and the method may further comprise: receiving, from the sender computing machine, data representing a lower bound value *a* of the first range of numbers, and data representing an upper bound value b of the first range of numbers.

In some embodiments, the first number may belong to a first range of numbers, and the proposed method may further comprise: receiving, from the sender computing machine, one or more of data representing a lower bound value *a* of the first range of numbers, and data representing a range of the first range of numbers. In some embodiments, the received data related to the first range of numbers may be used by the recipient computing machine to determine a constant offset to be used for reconstructing the exponent field of the binary code corresponding to the encoded second number.

In one or more embodiments, the first number may belong to a first range of numbers, and the method may further comprise: configuring the recipient computing machine with data representing the first range of numbers.

In one or more embodiments, the second number may belong to a second range of numbers, and the method may further comprise: receiving, from the sender computing machine, data representing the second range of numbers. In some embodiments, the second number may belong to a second range of numbers, and the method may further comprise: receiving, from the sender computing machine, one or more of a lower bound value of the second range of numbers and an upper bound value of the second range of numbers.

In one or more embodiments, the second number may belong to a second range of numbers, and the method may further comprise: configuring the recipient computing machine with data representing the second range of numbers.

In some embodiments, the second number may belong to a second range of numbers, and the proposed method may further comprise: receiving, from the sender computing machine, one or more of data representing a lower bound value of the second range of numbers, and data representing a range of the second range of numbers. Advantageously, in some embodiments, the received data related to the second range of numbers may be used by the recipient computing machine to determine a constant offset to be used for reconstructing the exponent field of the binary code corresponding to the encoded second number

**[0029]** In one or more embodiments, the first number may belong to a first range of numbers, and the second number may belong to a second range of numbers (which may be different from the first range of numbers). In such embodiments, the method may further comprise: obtaining one or more of data representing the first range of numbers and data representing the second range of numbers. In such embodiments, the method may further comprise: obtaining one or more of data representing a lower bound value *a* of the first range of numbers, and data representing an upper bound value *b* of the first range of numbers, wherein a < b. In some embodiments, the first number *r* may be determined by reverse transforming the second number $\tilde{r}$ using an inverse of a function that transforms numbers of the interval [*a*,*b*] (first range of numbers) into numbers of the interval [$2^i$, $2^{i+1}$[(second range of numbers), where *i* is a natural integer (*a* being a lower bound value of the first range of numbers, and *b* being an upper bound value of the first range of numbers, such that a < b).

In some embodiments, the function may be defined (for example configured at the recipient computing machine) to project the first range of numbers (for example an interval [*a*,*b*]) onto the second range of numbers (for example an interval of the type (expressible as) [$2^i$,$2^{i+1}$[ or, depending on the embodiment, of the type (expressible as) [$2^i$,$2^{i+1}$ - $\varepsilon$], where $0 < \varepsilon < 2^{i+1}$ - $2^i$). In some embodiments, the inverse function may be defined (for example configured at the recipient computing machine) to project the second range of numbers (for example an interval of the type [$2^i$,$2^{i+1}$[ or, depending on the embodiment, of the type (expressible as) [$2^i$,$2^{i+1}$ - $\varepsilon$], where $0 < \varepsilon < 2^{i+1}$ - $2^i$) onto the first range of numbers (for example an interval [*a*,*b*]).

In some embodiments, the second range of numbers may be of the type (expressible as) [$2^i$, $2^{i+1}$[ wherein i is a natural integer, and the proposed method may further comprise: receiving, for example from the sender computing machine (or in some embodiments from a configuration server of the computing environment), data related to the power *i*.

In some embodiments, the second range of numbers may be of the type [$2^i$,$2^{i+1}$ - $\varepsilon$], wherein *i* is a natural integer, and $0 < \varepsilon < 2^{i+1}$ - $2^i$, and the proposed method may further comprise: receiving, for example from the sender computing machine (or in some embodiments from a configuration server of the computing environment), data related to one or more of the power i and the number $\varepsilon$. In some embodiments, the recipient computing machine may be configured for using a second range of numbers of the type $2^{i+1}$[wherein *i* is a natural integer (which may be expressed in some embodiments as the type [$2^i$,$2^{i+1}$ - $\varepsilon$], wherein *i* is a natural integer, and $0 < \varepsilon < 2^{i+1}$ - $2^i$), and the recipient computing machine may obtain data based on which the value of the natural integer *i* can be determined.

In one or more embodiments, the first number may belong to a first range of numbers, and the second number may belong to a second range of numbers (which may be different from the first range of numbers).

In such embodiments, the first number r may be determined by reverse transforming the second number $\tilde{r}$ using an inverse of the following function f:

$$\tilde{r} := f(r) = \frac{1-\varepsilon}{b-a}r + \left(1 - \frac{1-\varepsilon}{b-a}a\right)$$

where $0 < \varepsilon < 1$, *a* is a lower bound value of the first range of numbers, b is an upper bound value of the first range of numbers, such that *a < b*. In such embodiments, the second range of numbers may be an interval of the type (expressible as) [1, 2 -$\varepsilon$].

In one or more embodiments, the first number r may be determined by reverse transforming the second number $\tilde{r}$ using an inverse of the following function *f:*

$$\tilde{r} := f(r) = \frac{2^i-\varepsilon}{b-a}r + \left(2^i - \frac{2^i-\varepsilon}{b-a}a\right)$$

where $\varepsilon$ is a real number such that $0 < \varepsilon < 2^{i+1} - 2^i$, *a* is a lower bound value of the first range of numbers, *b* is an upper bound value of the first range of numbers, such that $a < b$, and i is a natural integer. In some embodiments, the second range of numbers may be an interval of the type (expressible as) $[2^i, 2^{i+1} - \varepsilon]$.

In one or more embodiments, the data (transmitted by the sender computing machine, and received by the recipient computing machine) may carry the encoding of the second number according to the format with no sign field corresponding to the encoded second number.

In one or more embodiments, the second range is an interval of the type (expressible as) $[2^i, 2^{i+1}[$, where i is a natural integer. In one or more embodiments, the second range is an interval of the type (expressible as) $[2^i, 2^{i+1} - \varepsilon]$, where $0 < \varepsilon < 2^{i+1} - 2^i$ and i is a natural integer. In one or more embodiments, the second range is an interval of the type (expressible as) $[2^i, 2^{i+1} - \varepsilon]$, where $0 < \varepsilon < 2^{i+1} - 2^i$ and i is a natural integer, and the value of the real $\varepsilon$ may be based on (in some embodiments equal to) a distance between the lower bound $2^i$ and the next value representable by the format used for encoding floating-point numbers.

In one or more embodiments, the format is a double precision binary floating-point format for encoding floating-point numbers.

In one or more embodiments, the format is (a double precision binary floating-point format for encoding floating-point numbers) according to the IEEE 754 standard.

According to yet another aspect of the present subject disclosure, an apparatus (e.g. a hybrid computer system comprising both classical and quantum computation resources) is proposed, which comprises a processor, and a memory operatively coupled to the processor. The proposed apparatus is configured to perform embodiments of the proposed methods according to the present subject disclosure.

According to yet another aspect of the present subject disclosure, a non-transitory computer-readable medium encoded with executable instructions which, when executed on a non-quantum computer, causes a processor of the non-quantum computer, that is operatively coupled with a memory, to perform embodiments of the proposed method according to the present subject disclosure, is proposed.

According to yet another aspect of the present subject disclosure, a computer program product comprising computer program code (in some embodiments tangibly) embodied in a computer readable medium, said computer program code comprising instructions to, when provided to a non-quantum computer system and executed, cause said computer to perform embodiments of the proposed method according to the present subject disclosure, is proposed.

It should be appreciated that the present invention can be implemented and utilized in numerous ways, including without limitation as a process, an apparatus, a system, a device, and as a method for applications now known and later developed. These and other unique features of the system disclosed herein will become more readily apparent from the following description and the accompanying drawings.

## Brief description of the drawings

The present subject disclosure will be better understood and its numerous objects and advantages will become more apparent to those skilled in the art by reference to the following drawings, in conjunction with the accompanying specification, in which:

Figure 1 is a block diagram illustrating an exemplary architecture of a computing environment for implementing one or more of the proposed methods, in accordance with one or more embodiments;
Figure 2 is a diagram illustrating one remote qubit gate application in distributed quantum simulation between two processors, in accordance with one or more embodiments;
Figure 3 illustrates the layout of bit fields according to a double binary format defined by the IEEE 754 standard that may be used in one or more embodiments;

Figure 4a is a flow chart illustrating a proposed scheme of transmitting data representing a first (real) number from a sender computing machine to a recipient computing machine in accordance with one or more embodiments;

Figure 4b is a flow chart illustrating a proposed scheme of receiving data representing a first (real) number from a sender computing machine in accordance with one or more embodiments;

Figs. 5a - 5d illustrate different bit packaging of a mantissa according to one or more embodiments;

Figure 6 is a diagram illustrating an exemplary architecture of a computer system for implementing a proposed method, in accordance with one or more embodiments.

## Description of embodiments

The advantages, and other features of the components disclosed herein, will become more readily apparent to those having ordinary skill in the art form. The following detailed description of certain preferred embodiments, taken in conjunction with the drawings, sets forth representative embodiments of the subject technology, wherein like reference numerals identify similar structural elements.

For simplicity and clarity of illustration, the drawing figures illustrate the general manner of construction, and descriptions and details of well-known features and techniques may be omitted to avoid unnecessarily obscuring the discussion of the described embodiments of the subject disclosure. Additionally, elements in the drawing figures are not necessarily drawn to scale. For example, the dimensions of some of the elements in the figures may be exaggerated relative to other elements to help improve understanding of embodiments of the present subject disclosure. Certain figures may be shown in an idealized fashion in order to aid understanding, such as when structures are shown having straight lines, sharp angles, and/or parallel planes or the like that under real-world conditions would likely be significantly less symmetric and orderly.

In addition, it should be apparent that the teaching herein can be embodied in a wide variety of forms and that any specific structure and/or function disclosed herein is merely representative. In particular, one skilled in the art will appreciate that an aspect disclosed herein can be implemented independently of any other aspects and that several aspects can be combined in various ways.

The present disclosure is described below with reference to functions, engines, block diagrams and flowchart illustrations of the methods, systems, and computer program according to one or more exemplary embodiments. Each described function, engine, block of the block diagrams and flowchart illustrations can be implemented in hardware, software, firmware, middleware, microcode, or any suitable combination thereof. If implemented in software, the functions, engines, blocks of the block diagrams and/or flowchart illustrations can be implemented by computer program instructions or software code, which may be stored or transmitted over a computer-readable medium, or loaded onto a general purpose non quantum computer, special purpose non quantum computer or other programmable data processing apparatus to produce a machine, such that the computer program instructions or software code which execute on the non quantum computer or other programmable data processing apparatus, create the means for implementing the functions described herein.

Embodiments of computer-readable media include, but are not limited to, both computer storage media and communication media including any medium that facilitates transfer of a computer program from one place to another. As used herein, a "computer storage media" may be any physical media that can be accessed by a computer. Examples of computer storage media include, but are not limited to, a flash drive or other flash memory devices (e.g. memory keys, memory sticks, key drive), CD-ROM or other optical storage, DVD, magnetic disk storage or other magnetic storage devices, memory chip, RAM, ROM, EEPROM, smart cards, Solid State Drive (SSD) devices or Hard Disk Drive (HDD) devices, or any other suitable medium from that can be used to carry or store program code in the form of instructions or data structures which can be read by a computer processor. Also, various forms of computer-readable media may transmit or carry instructions to a computer, including a router, gateway, server, or other transmission device, wired (coaxial cable, fiber, twisted pair, DSL cable) or wireless (infrared, radio, cellular, microwave). The instructions may comprise code from any computer-programming language, including, but not limited to, assembly, C, C++, Visual Basic, HTML, PHP, Java, Javascript, Python, and bash scripting.

Unless specifically stated otherwise, it will be appreciated that throughout the following description discussions utilizing terms such as processing, computing, calculating, determining, generating, or the like, refer to the action or processes of a computer or computing system, or similar electronic computing device, that manipulate or transform data represented as physical, such as electronic, quantities within the registers or memories of the computing system into other data similarly represented as physical quantities within the memories, registers or other such information storage, transmission or display devices of the computing system.

The terms "comprise," "include," "have," and any variations thereof, are intended to cover a non-exclusive inclusion, such that a process, method, article, or apparatus that comprises a list of elements is not necessarily limited to those elements, but may include other elements not expressly listed or inherent to such process, method, article, or apparatus.

The terms "computing machine," "computer", "computing node", "computing apparatus", "processing apparatus", "processing node" or "core" as used in the present subject disclosure are intended to cover without limitation any computer, processor, calculator, computing system, computing node, computing task, computer job, processing, algorithm, and processing resource, processing or computing operation, configured to use or exploit (depending on the embodiments quantum or non quantum) mechanical phenomena.

The terms "quantum" or "quantum computing" as used in the present subject disclosure are intended to cover any computer, computing system, processing or computing operation, configured to use or exploit quantum mechanical phenomena. A computer, processor, calculator, computing system, computing node, computing task, computer job, processing, algorithm, and processing resource configured to use or exploit quantum mechanical phenomena will be referred to herein as "quantum" (a quantum computer, quantum processor, quantum calculator, quantum computing system, quantum computing node, quantum computing task, quantum computer job, quantum processing, quantum algorithm, and quantum processing resource, respectively. In contrast, a computer, processor, calculator, computing system, computing node, computing task, computer job, processing, algorithm, and processing resource which is not configured to use or exploit quantum mechanical phenomena may be referred to herein as "classical" or "non-quantum" (a classical computer, classical processor, classical calculator, classical computing system, classical computing node, classical computing task, classical computer job, classical algorithm, classical processing, classical processing resource, respectively). A quantum processor (also referred to herein as a quantum processing unit (or QPU)) may be configured to perform both quantum processing and classical processing.

The term « hybrid » as used in the present subject disclosure, for example as applied to a computer, an algorithm, a computer task, a computer job, refers to the combination of classical and quantum.

Additionally, the word "exemplary" as used herein means serving as an example, instance, or illustration. Any aspect or design described herein as "exemplary" is not necessarily to be construed as preferred or advantageous over other aspects or designs.

The present subject disclosure may advantageously be implemented on any computing machine of a distributed computing environment comprising several computing machines (e.g. processors) operatively coupled with each other for data communication, for example through a data communication network (e.g. an Ethernet-based packet data communication network). Examples of a computing machine on which embodiments of the present subject disclosure may advantageously be implemented include, without being limited to, a processor, which may be any suitable microprocessor, microcontroller, processing core, Central Processing Unit (CPU), Quantum processing Unit (QPU), Field Programmable Gate Arrays (FPGA), Application Specific Integrated Circuits (ASIC), Digital Signal Processing chip, and/or state machine, or a combination thereof.

In the following, proposed methods according to embodiments of the present subject disclosure are described in the context of a distributed computing environment usable for distributed quantum circuit simulation. However, the skilled person would understand that this context is merely exemplary and illustrative, and that embodiments of the proposed methods may be used for data communication between two computing nodes (machines) of a distributed computing environment in a context other than distributed quantum circuit simulation.

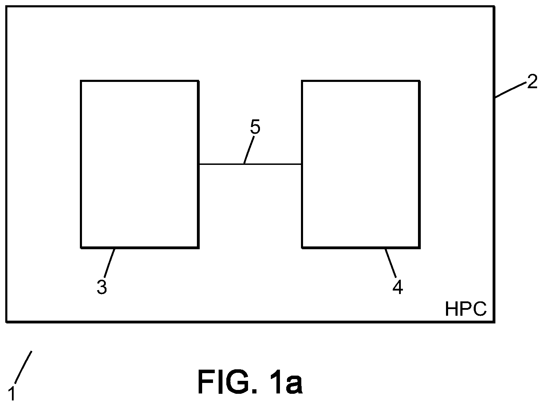

Figure 1 illustrates a computing environment (1) in which the proposed method may advantageously be implemented.

The computing environment (1) may typically be a High Performance Computing (HPC) environment which comprises one or more HPC center (2).

The exemplary HPC center (2) shown on Fig. 1 may be viewed as an exemplary hybrid computing environment in that it may comprise a classical computing cluster (e.g. a HPC cluster) (3) comprising classical resources, that is, non-quantum computation resources (e.g. one or more non-quantum processors, such as CPUs), as well as a quantum computing unit (4) comprising quantum resources (e.g. one or more quantum processors, such as QPUs). In some embodiments, the classical computing cluster (3) and the quantum computing unit (4) may be operatively connected, for example via any suitable data communication bus (5).

In some embodiments, the HPC center (2) comprises a first scheduler, for example of the type configurable for managing classical resources of the classical computing cluster (3).

In one or more embodiments, the scope of management of the first scheduler may be extended to management of all types of computation resources of the HPC center (2). That is, the first scheduler may be configured for managing classical resources of the computing cluster (3) as well as quantum resources of the quantum computing unit (4). In some embodiments, the first scheduler may therefore be a component (function) (which may be, in all or in part, implemented in software) tasked with managing the allocation of any of the processing resources of the HPC center (2) to computer jobs to be executed.

Various allocation schemes may be considered, and the first scheduler may for example be designed to fairly share resources among users. For example, based on a user submitting a computation with a set of parameters (type of resources, number of resources, etc.), the first scheduler may be configured to execute this computation "at the best time".

In one or more embodiments, the first scheduler may typically be configured for one or more of: (1) Maximizing the usage of the more expensive resource(s) (in the case of a hybrid HPC, the quantum computing resource(s)), (2) Fairly sharing resources between users (based on a specific policy), and (3) Avoiding resource conflict, so that a resource be used by a single job at a given time.

Quantum circuit simulations make it possible to precisely analyze the relevance of numerous quantum algorithms, using a relatively small number of qubits. As current quantum processors have not achieved high enough computational accuracy, quantum simulators provide an alternative classical method for solving some industrial problems (for which quantum algorithms exist). The simulation of quantum algorithms, particularly on distributed systems (allowing to simulate a larger number of qubits), has been a major research interest in recent years.

*Distributed Quantum Circuit Simulation*

Simulators representing the state vector using an array of complex amplitudes can be adapted to run on distributed architectures, using $2^n$ nodes (n being an arbitrary positive integer). The state vector is split into $2^n$ subarrays having the same size.

For instance, in cases where a state vector is split up to run on $2^1$ nodes:

States matching $|0...\rangle$ will be stored on the 1st node.
States matching $|1...\rangle$ will be stored on the 2nd node.

As another example, in cases where the state vector is split up to run on $2^2$ nodes:

States matching $|00...\rangle$ will be stored on the 1st node.
States matching $|01...\rangle$ will be stored on the 2nd node.
States matching $|10...\rangle$ will be stored on the 3rd node.
States matching $|11...\rangle$ will be stored on the 4th node.

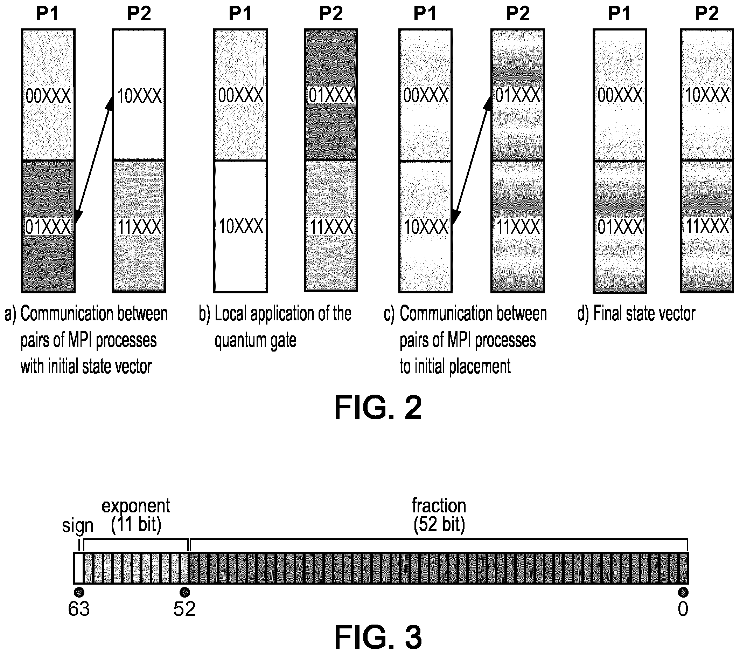

In cases of using $2^n$ nodes to store a state vector, each state stored on the same node will share the same n qubits at the beginning, the remaining k qubits differ. Applying a gate on these k qubits does not involve communication (as all the states required for the gate application are stored on the same node). Nevertheless, applying a gate on the first *n* qubits involves data communication, which is why they are called remote gates, while those that only involves the last k qubits are called local gates. For the same reason, the first *n* qubits are called remote qubits, and the last *k* qubits are called local qubits. An example of application of a remote one-qubit gate is shown in figure 2.

Figure 2 shows an exemplary implementation of an exemplary 1 remote qubit gate application in distributed quantum simulation between two processors (denoted P1 and P2).

The exemplary implementation illustrated on Fig. 2 comprises a first operation comprising a communication between pairs of Message Passing Interface (MPI) processes with initial state vector. The Message Passing Interface (MPI) may be any suitable application configured for passing messages between multiple MPI processes running in parallel on multiple computing machines in a distributed computing environment.

According to a second operation (subsequent to the first operation), a local application of the quantum gate is performed.

As shown in Fig. 2, in some embodiments a third operation may then be performed which comprises a communication between pairs of MPI processes to return the subarray to their initial placement.

This may lead to generating the final state vector.

Given that one of the main advantages of performing distributed simulation is to open the possibility to handle larger and more complex circuits, the volume of data that must be communicated between nodes may in some cases be substantial. This volume scales exponentially with the number of qubits in the simulated circuit and linearly with the number of remote gates. As is often the case, the bandwidth of the inter-node network becomes the bottleneck, limiting the overall performance of the simulation.

A wide range of optimization methods are being explored to minimize the data communication required for simulation, particularly through the compilation of the initial quantum circuit. There are also some straightforward techniques, such as recognizing that returning the qubits to their initial order after a remote gate application is redundant. This operation can be omitted by simply keeping track of the current qubit permutation. Other conventional methods aiming to simplify the implementation of remote gate operations have also been developed, for instance by adding one or more remote SWAP gates to the initial circuit to localize the remote qubits (the SWAP gates operating to swap the states of multiple (for example two) qubits.

According to one or more embodiments, proposed methods of the present subject disclosure when used in the context of distributed quantum circuit simulation advantageously leverage specific characteristics of the quantum state vector to reduce data communication, notably the values of the state amplitudes that are represented in complex numbers in the form *x + iy,* where *x* and *y* are two floating-point numbers within the interval [-1, 1].

The present subject disclosure provides a scheme for reducing data exchanged between two computing machines (for example two processors used for distributed quantum circuit simulation) which can advantageously be used in the specific use case of distributed quantum circuit simulation for reducing data exchanged between two computing machines for transmission from one computing machine to another computing machine of floating-point numbers (in particular floating-point numbers that belong to the interval [-1, 1]).

*Double precision binary floating-point format*

The Institute of Electrical and Electronics Engineers (IEEE) Standard for Floating-Point Arithmetic (IEEE 754) standard addresses various aspects of floating-point arithmetic, among which it defines a double precision binary floating-point format. The double-precision floating-point format is a floating-point number format which represents a range of numerical values using a floating radix point, usually on 64 bits in computer memory. In the IEEE 754 standard, the double precision binary floating-point format (64-bit base-2 format) is referred to as "binary64" (and is called "double" in the IEEE 754-1985 version of the standard). The IEEE 754 standard specifies the binary64 format as follows:

- Sign bit (1 bit): it determines the sign of the floating-point number,
- Exponent (11 bits): it is represented as an unsigned integer from 0 to 2047 in biased form, in the sense that it is an offset to define an exponent ranging from - 1022 to +1023,
- Significand precision or mantissa (53 bits, 52 explicitly stored): it gives from 15 to 17 significant decimal digits.

Fig. 3 illustrates the layout of the sign bit, the exponent bits and the fraction bits according to a double binary format defined by the IEEE 754 standard.

As encoded according to this format, a real number r may be written as follows:

$$r = (-1)^s \left( 1 + \sum_{i=1}^{52} b_{52-i} 2^{-i} \right) \times 2^{e-1023}$$

[Eq. 1]

where s is the sign bit, $b_i$ are the mantissa bits and e is the biased form exponent part.

*Mantissa (significand precision) transmission*

Taking into account the fact that a simple precision is not sufficient for some calculations (in particular in the distributed quantum circuit simulation context) and that the complex amplitudes are contained in the unit circle, the present subject disclosure introduces the concept of projecting the values (to be transmitted (communicated) from one computing node to another computing node in a distributed computing environment) in a range in which the exponent part is constant, so as to advantageously transmit (communicate) only the significand precision part of the complex amplitudes to minimize the volume of the transmitted (communicated) data.

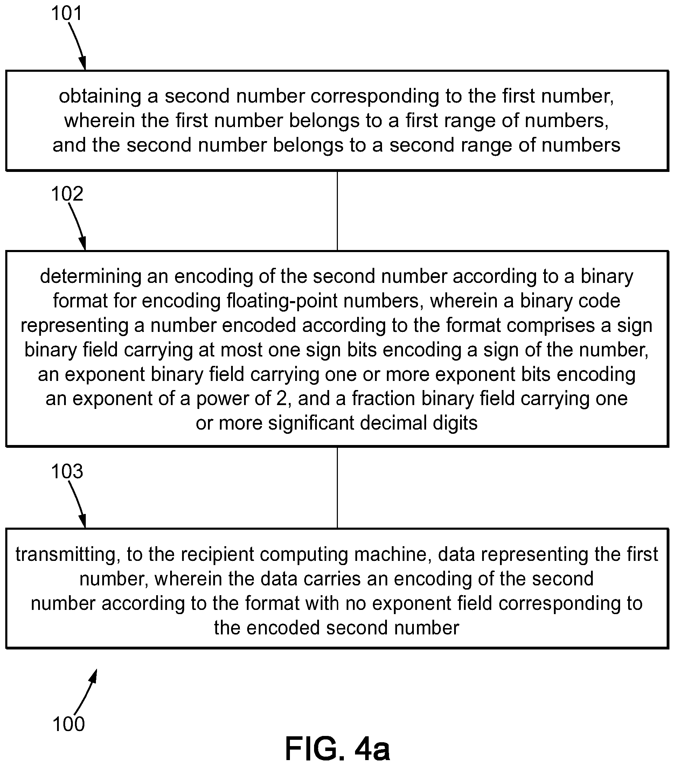

Fig. 4a shows a flow chart illustrating the transmitting (100) of data representing a first (real) number from a sender computing machine to a recipient computing machine according to embodiments of the present subject disclosure.

One may consider a distributed computing environment comprising a first computing machine (comprising one or more processors) and a second computing machine (comprising one or more processors) operatively coupled to each other for data communication.

For example, in the exemplary context of distributed quantum circuit simulation, one may consider a hybrid computer configured with processing resources comprising one or more central processing unit, CPU, processing resources and at least one quantum processing unit, QPU, processing resources, such as for example the HPC center (2) of Fig. 1.

In one or more embodiments, transmitting a first (real) number r which belongs to a first range of numbers from the first computing machine (which may also be referred to herein as a "sender computing machine" or a "sender computer") to the second computing machine (which may also be referred to herein as a "recipient computing machine" or a "recipient computer") may comprise obtaining (101) a second (real) number r̃ corresponding to the first (real) number, the second (real) number belonging to a second range of numbers.

In some embodiments, the second (real) number r̃ may be computed by projecting the value of the first (real) number r onto a predefined range in which the exponent part is constant, so that only the significand precision part of the binary64 format of the second (real) number may be transmitted to a recipient computing machine.

For example, in one or more embodiments in the specific context of distributed quantum circuit simulation described in relation to Fig. 2, the state amplitudes of a quantum state vector may be represented in a complex number form $x + iy$, where $x$ and $y$ are two floating-point numbers within the interval [-1, 1]. In such example, each of $x$ and $x$ may be a real number that belongs to the first range of numbers [-1, 1], and the proposed method may advantageously be used for each of the $x$ and $x$ numbers.

In some embodiments, given a first (real) number r belonging to the range [-1, 1], a second (real) number $\tilde{r}$ which belongs to the range [1,2 - $\varepsilon$] (where $0 < \varepsilon < 1$, for example $\varepsilon = 2^{-52}$) may be obtained (in some embodiments computed) based on the first (real) number $r$.

Therefore, in some embodiments, a first (real) number r belonging to the range [-1, 1] may be injected in (projected onto) the range [1,2 - $\varepsilon$] (using a projection function (for example denoted $f$)), where $\varepsilon = 2^{-52}$ is the difference between 1 and the next value that can be represented by the double precision floating-point format.

Therefore, in some embodiments, the first range in which the first number belongs may be known to the sender computing machine and the recipient computing machine (for example the first range may be preconfigured in the sender computing machine and the recipient computing machine, for example by a configuration server of the distributed computing environment).

In some embodiments, the first range may be [-1,1], and the second range may be defined as $[2^i, 2^{i+1}[$, where $i = 0$, which may in some embodiments be formulated (expressed) as [1,2 - $\varepsilon$], where $0 < \varepsilon < 1$. The use of a representation of the second range of the type [1,2 - $\varepsilon$], where $0 < \varepsilon < 1$, instead of $[2^i, 2^{i+1}[$, where $i = 0$ advantageously allows ensuring that the projected value is included in the second range $[2^i, 2^{i+1}[$, as the parameter $\varepsilon$ may be used for expressing the projection function f.

In some embodiments in which the double binary format defined by the IEEE 754 standard is used, the value of the parameter $\varepsilon$ may be chosen to be based on (in some embodiments equal to) $(2^{i+1} - 2^i)/2^{52}$, which advantageously corresponds to a value of $\varepsilon$ such that $2^i + \varepsilon$ is the first value that can be represented after $2^i$ (according to double binary format used for encoding floating-point numbers). Therefore, in embodiments where i = 0, and the parameter $\varepsilon$ may be chosen equal to $2^{-52}$.

In one or more embodiments, given a first (real) number r belonging to a range [a,b], where a and b are real numbers such that $a < b$, a second (real) number $\tilde{r}$ may be computed by applying the following function f:

$$f : [a, b] \longrightarrow [1, 2 - \varepsilon] \subset [1, 2[$$

which associates to a first (real) number r a corresponding second (real) number $\tilde{r} \in [1, 2 - \varepsilon]$ (where $0 < \varepsilon < 1$ and may advantageously be chosen in some embodiments as $\varepsilon = 2^{-52}$ as described above) such that:

$$\tilde{r} := f(r) = \frac{1 - \varepsilon}{b - a} r + \left( 1 - \frac{1 - \varepsilon}{b - a} a \right)$$

[Eq. 2]

More generally, in one or more embodiments, given a first (real) number $r$ belonging to a range [a,b], where a and b are real numbers such that $a < b$, a second (real) number $\tilde{r}$ may be computed (determined) by applying to the first (real) number r any suitable projection function $f$ that operates to project any first number of the range [a,b] into a corresponding second number of the range $[2^i, 2^{i+1}[$, where $i$ is a natural integer, the projection of the first (real) number $r$ resulting to the second (real) number $\tilde{r}$. The projection function may be any suitable function that associates any first number of the range [a,b] with a corresponding second number of the range $[2^i, 2^{i+1}[$.

In one or more embodiments, given a first (real) number $r$ belonging to a range [a,b], where a and b are real numbers such that $a < b$, a second (real) number $\tilde{r}$ may be computed (determined) by applying to the first (real) number r any suitable projection function $f$ that operates to project any first number of the range [a,b] into a corresponding second number of the range $[2^i, 2^{i+1} - \varepsilon]$, where i is a natural integer

$$f : [a, b] \longrightarrow [2^i, 2^{i+1} - \varepsilon] \subset [2^i, 2^{i+1}[$$

and $\varepsilon$ is a real number of the range $0 < \varepsilon < 2^{i+1} - 2^i$: the projection of the first (real) number r resulting to the second (real) number $\tilde{r}$. The projection function may be any suitable function that associates any first number of the range [a,b] with a corresponding second number of the range $[2^i, 2^{i+1} - \varepsilon]$.

For example, in one or more embodiments, given a first (real) number r belonging to a range [*a*,*b*], where *a* and b are real numbers such that *a* < *b*, a second (real) number *r̃* may be computed by applying the following projection function f:

$$f : [a, b] \longrightarrow [2^i, 2^{i+1} - \varepsilon] \subset [2^i, 2^{i+1}[$$

which associates to any first (real) number r belonging to the range [*a*,*b*] a respectively corresponding second (real) number $\tilde{r} \in [2^i, 2^{i+1} - \varepsilon]$ (where $0 < \varepsilon < 2^{i+1} - 2^i$, and i is a natural integer) such that:

$$\tilde{r} := f(r) = \frac{2^i - \varepsilon}{b - a} r + \left( 2^i - \frac{2^i - \varepsilon}{b - a} a \right)$$

[Eq. 2']

In one or more embodiments, the value of the parameter $\varepsilon$ may be chosen to be based on (in some embodiments equal to) a distance between the lower bound $2^i$ and the next value representable by the floating-point format used for encoding floating-point numbers (for example in some embodiments between the lower bound $2^i$ and the next value representable by the floating-point format used for encoding floating-point numbers).

For example, in some embodiments in which the double binary format defined by the IEEE 754 standard is used for encoding floating-point numbers, the value of the parameter $\varepsilon$ may be chosen to be based on (in some embodiments equal to) $(2^{i+1} - 2^i)/2^{52}$, which advantageously corresponds to a value of $\varepsilon$ such that $2^i + \varepsilon$ is the first value that can be represented by the double binary format defined by the IEEE 754 standard after the lower bound $2^i$.

Depending on the embodiment, any other suitable function f that operates (on numbers of the interval [*a*,*b*]) to project the interval [*a*,*b*] (first range of numbers) onto the interval of projection $[2^i, 2^{i+1} - \varepsilon]$ (second range of numbers) where i is a natural integer and with $0 < \varepsilon < 2^{i+1} - 2^i$ (for example [1,2 - $\varepsilon$] for i = 0, with $0 < \varepsilon < 1$ (e.g. $\varepsilon = 2^{-52}$)) may be used in the proposed methods according to embodiments of the present subject disclosure. In one or more embodiments, the function f may be chosen as a function that projects the first range of numbers into the second range of numbers by associating a respectively corresponding second number of the second range of numbers to any first number of the first range of numbers.

In some embodiments, the use of a second range of the type $[2^i, 2^{i+1} - \varepsilon]$, where $0 < \varepsilon < 2^{i+1} - 2^i$, instead of $[2^i, 2^{i+1}[$, where i is a natural integer advantageously allows ensuring that the projected value is included in the second range $[2^i, 2^{i+1}[$, as the parameter $\varepsilon$ may be used in the expression of the projection function f.

In some embodiments in which the double binary format defined by the IEEE 754 standard is used, the value of the parameter $\varepsilon$ may be chosen to be based on (in some embodiments equal to) $(2^{i+1} - 2^i)/2^{52}$, which advantageously corresponds to a value of $\varepsilon$ such that $2^i + \varepsilon$ is the first value that can be represented (according to double binary format used for encoding floating-point numbers) after $2^i$.

As the second (real) number *r̃* in some embodiments belongs to the range $[2^i, 2^{i+1} - \varepsilon]$, where i is a natural integer and $\varepsilon$ is a real number of the range $0 < \varepsilon < 2^{i+1} - 2^i$, an encoding of this second (real) number *r̃* according to a double precision binary floating-point format (for example the IEEE 754 double precision binary floating-point format) may advantageously have an exponent bit field which is constant, which therefore does not contain information that would need to be included in data representing an encoding of the second (real) number *r̃* that is to be transmitted to a recipient computer. In some embodiments, the recipient computer may indeed be provided with information based on which it can reconstruct an entire encoding of the second (real) number *r̃* based on a received partial encoding of such number which does not include an (entire) exponent bit field. In some embodiments, the recipient computer may indeed be provided with information based on which it can reconstruct an exponent (bit) field of an encoding of the second (real) number *r̃* based on a received partial encoding of such number which does not include an (entire) exponent bit field.

For example, in embodiments in which i = 0, as the second (real) number *r̃* in some embodiments belongs to the range [1,2 - $\varepsilon$] where $\varepsilon$ may be chosen equal to $2^{-52}$, an encoding of this number *r̃* according to the IEEE 754 double precision binary floating-point format may advantageously have an exponent bit field which is constant and therefore does not contain information that would need to be included in data representing an encoding of the second (real) number *r̃* that is to be transmitted to a recipient computer.

In one or more embodiments, transmission to a recipient computer of the second (real) number encoded according to the binary64 format may advantageously be performed without transmitting to the recipient computer the exponent bit field of the binary64 encoding, that is, by transmitting the sign bit and the mantissa bit field of the binary64 encoding without the exponent bit field, so as to decrease the amount of transmitted data while transmitting to the recipient computer data usable for reconstructing at the recipient computer the binary64 encoding of the second (real) number based on the received data. In some embodiments, transmission to a recipient computer of the second (real) number encoded according to the binary64 format may advantageously be performed without transmitting to the recipient computer the entire exponent bit field of the binary64 encoding, that is, by transmitting the sign bit and the mantissa bit field of the binary64 encoding with only part of the exponent bit field, so as to decrease the amount of transmitted data while transmitting to the recipient computer data usable for reconstructing at the recipient computer the binary64 encoding of the second (real) number based on the received data.

In one or more embodiments, the recipient computer may be configured to determine, based on received data that represents a binary64 encoding of a real number that comprises a sign bit and a mantissa bit field, with no exponent bit field, that the exponent bit field of the received binary64 encoding is constant, so that it may reconstruct the complete binary64 encoding of the real number based on the received binary64 bit fields. In some embodiments, the recipient computer may be configured to determine, based on received data that represents a binary64 encoding of a real number that comprises a sign bit and a mantissa bit field, with only part of an exponent bit field, that the exponent bit field of the received binary64 encoding is constant, so that it may reconstruct the complete binary64 encoding of the real number based on the received binary64 bit fields.

In one or more embodiments, the proposed scheme (100) illustrated on Fig. 4a may comprise determining (102) an encoding of the second (real) number according to a binary format for encoding floating-point numbers.

In some embodiments, a binary code representing a number encoded according to the format may comprise one or more of: a sign binary field carrying at most one sign bit (zero or one sign bit) encoding a sign of the number, an exponent binary field carrying one or more exponent bits encoding an exponent of a power of 2, and a fraction binary field carrying one or more significant decimal digits.

In one or more embodiments, the binary code representing the number encoded according to the format may comprise an exponent binary field carrying one or more exponent bits encoding an exponent of a power of 2, and a fraction binary field carrying one or more significant decimal digits.

In one or more embodiments, the second range of values to which the second (real) number belongs may be chosen so that the exponent binary field of the binary code be constant (and therefore be a known constant offset). In the exemplary case where the second range (interval of projection) is of the type $[2^i, 2^{i+1} - \varepsilon]$ (second range of numbers) where $i = 0$ and $0 < \varepsilon < 2^{i+1} - 2^i$, the constant offset corresponding to the second range is equal to $1023 = 2^{10} - 1$. Advantageously, since the exponent binary field is known, it can be rebuilt (generated) by a recipient computing machine with no need to be included in data transmitted by a sender computing machine. The present subject disclosure provides that in order to transmit the first (real) number to a recipient computer, the transmission to the recipient computer of the constant exponent binary field of the encoding of the second (real) number may be skipped (may not be performed), so as to decrease the amount of data transmitted to the recipient computer.

In one or more embodiments, data representing the first (real) number that carries an encoding of the second (real) number according to the format with no exponent field corresponding to the encoded second (real) number may be transmitted (103) to the recipient computing machine.

In one or more embodiments, further to determining an encoding of the second (real) number according to a binary format for encoding floating-point numbers, the proposed scheme may proceed with extracting, from the encoding of the second (real) number a mantissa (significand precision) binary code, and with transmitting, to the recipient computing machine, data representing the first (real) number by transmitting the extracted mantissa binary code with no exponent field corresponding to the encoded second (real) number.

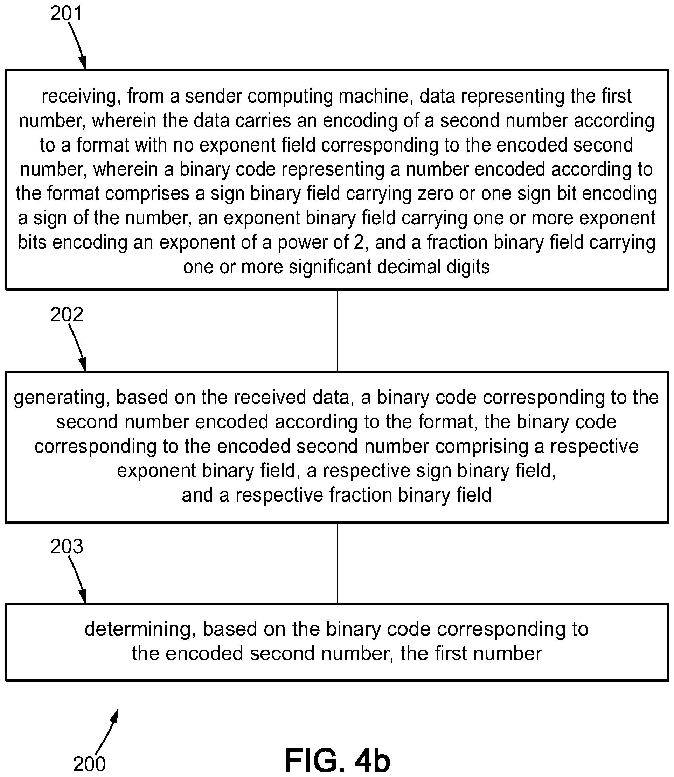

Fig. 4b shows a flow chart illustrating the receiving (200) of data representing a first (real) number from a sender computing machine by a recipient computing machine according to embodiments of the present subject disclosure.

One may consider a distributed computing environment comprising a first computing machine (comprising one or more processors) and a second computing machine (comprising one or more processors) operatively coupled to each other for data communication.

For example, in the exemplary context of distributed quantum circuit simulation, one may consider a hybrid computer configured with processing resources comprising one or more central processing unit, CPU, processing resources and at least one quantum processing unit, QPU, processing resources, such as for example the HPC center (2) of Fig. 1.

In one or more embodiments, receiving (200) a first (real) number from a first computing machine (which may also be referred to herein as a "sender computing machine" or a "sender computer") (e.g. a sender processor) in a distributed computing environment may be performed by a second computing machine (which may also be referred to herein as a "recipient computing machine" or "recipient computer") (e.g. a recipient processor) of the distributed computing environment, and may comprise receiving (201), from the sender computing machine, data representing the first (real) number. In some embodiments, the data may carry an encoding of a second (real) number according to a format with no exponent field corresponding to the encoded second (real) number. In some embodiments, a binary code representing a number encoded according to the format may comprise an exponent binary field carrying one or more exponent bits encoding an exponent of a power of 2, and one or more of a sign binary field carrying zero or one sign bit encoding a sign of the number, and a fraction binary field carrying one or more significant decimal digits, such as for example according to the IEEE 754 double precision binary floating-point format.

In one or more embodiments, further to receiving the data representing the first (real) number, a binary code corresponding to the second (real) number encoded according to the format may be generated (202), based on the received data. In some embodiments, the binary code corresponding to the encoded second (real) number may comprise a respective exponent binary field, a respective sign binary field, and a respective fraction binary field, even though no exponent field has been received from the first computing machine.

In one or more embodiments, upon reconstructing the encoded second (real) number, the first (real) number may be determined (203) based on the encoded second (real) number.

In one or more embodiments, the first (real) number may belong to a first range of numbers $[a,b]$ ($a < b$), and the second (real) number may belong to a second range of numbers (e.g. of the type (that can be expressed as) $[2^i, 2^{i+1}[$, where $i$ is a natural integer, or of the type $[2^i, 2^{i+1} - \varepsilon]$, where $0 < \varepsilon < 2^{i+1} - 2^i$).

In order for the recipient computer to decode received data that is transmitted according to embodiments of proposed schemes of the present subject disclosure, the recipient computer may be provided with information usable for such decoding. Depending on the embodiment, the recipient computer may be preconfigured with information usable for such decoding or may receive information usable for such decoding (from the sender computer or a configuration server of the computing environment).

Depending on the embodiment, the recipient computer may be preconfigured with data representing the first range of (real) numbers, or may receive data representing the first range of (real) numbers (from the sender computer or a configuration server of the computing environment). In one or more embodiments, the data representing the first range of (real) numbers may comprise one or more of data representing a lower bound value $a$ of the first range of (real) numbers, and data representing an upper bound value b of the first range of (real) numbers. In one or more embodiments, the data representing the first range of (real) numbers may comprise one or more of data representing a (e.g. lower, upper) bound value of the first range of numbers, and data representing a range of the first range of numbers.

For example, in one or more embodiments, the sender computer may transmit, to the recipient computer, data representing the first range of (real) numbers. Correspondingly, in some embodiments, the recipient computer may receive, from the sender computer, data representing the first range of (real) numbers, which in some embodiments may comprise one or more of data representing a lower bound value $a$ of the first range of (real) numbers, and data representing an upper bound value b of the first range of (real) numbers.

In some embodiments, the data representing the first range of (real) numbers may be used by the recipient computer to determine (e.g. identify) an inverse of the projection function $f$ that associates the first (real) number and the second (real) number, such as for example according to Eq. 2.

In some embodiments, the data representing the first range of (real) numbers may be used by the recipient computer to reconstruct the encoded second (real) number based on received data.

In such embodiments, the data representing the first range of (real) numbers may be used by the recipient computer to determine a constant value corresponding to a constant offset value to be used to reconstruct an exponent binary field the encoded second (real) number.

As another example, depending on the embodiment, the recipient computer may be preconfigured with data representing the second range of (real) numbers, or may receive data representing the second range of (real) numbers (from the sender computer or a configuration server of the computing environment). In some embodiments, the data representing the second range of (real) numbers may comprise one or more of data representing a lower bound value of the second range of (real) numbers, and data representing an upper bound value of the second range of (real) numbers. In one or more embodiments, the data representing the second range of (real) numbers may comprise one or more of data representing a (e.g. lower, upper) bound value of the second range of numbers, and data representing a range of the second range of numbers.

In some embodiments in which the second range of numbers is of the type $[2^i, 2^{i+1}[$, where $i$ is a natural integer, the data representing the second range of (real) numbers may comprise data related to the power $i$. In some embodiments in which the second range of numbers is of the type $[1, 2 - \varepsilon]$, where $0 < \varepsilon < 1$, the data representing the second range of (real) numbers may comprise data related to the number $\varepsilon$.

In some embodiments in which the second range of numbers is of the type $[2^i, 2^{i+1} - \varepsilon]$, where $0 < \varepsilon < 2^{i+1} - 2^i$ and $i$ is a natural integer, the data representing the second range of (real) numbers may comprise data related to one or more of the number $\varepsilon$ and the number $i$.

For example, in one or more embodiments, the sender computer may transmit, to the recipient computer, data representing the second range of (real) numbers. Correspondingly, in some embodiments, the recipient computer may receive, from the sender computer, data representing the second range of (real) numbers, which in some embodiments may comprise one or more of data representing a lower bound value of the second range of (real) numbers, and data representing an upper bound value of the second range of (real) numbers.

In such embodiments, the data representing the second range of (real) numbers may be used by the recipient computer to determine (e.g. identify) an inverse of the projection function $f$ that associates the first (real) number and the second (real) number, such as for example according to Eq. 2.

In some embodiments, the data representing the second range of (real) numbers may be used by the recipient computer to reconstruct the encoded second (real) number based on received data.

In such embodiments, the data representing the second range of (real) numbers may be used by the recipient computer to determine a constant value corresponding to a constant offset value to be used to reconstruct an exponent binary field the encoded second (real) number.

For example, in embodiments in which the second range of numbers is of the type $[2^i, 2^{i+1}[$, where $i = 0$ (the second range (interval of projection) may be of the equivalent type $[1, 2 - \varepsilon]$), the constant offset value can be determined as equal to $1023 = 2^{10} - 1$.

As yet another example, in one or more embodiments, depending on the embodiment, the recipient computer may be preconfigured with data representing the constant offset value, or may receive data representing the constant offset value (from the sender computer or a configuration server of the computing environment). In some embodiments, the recipient computer may be configured to determine, based on the constant offset value, the second range of (real) numbers.

As yet another example, depending on the embodiment, the recipient computer may be preconfigured with data representing a projection function that associates any number in the first range of (real) numbers with a corresponding number in the second range of (real) numbers, or may receive data representing such a projection function (from the sender computer or a configuration server of the computing environment).

As yet another example, depending on the embodiment, the recipient computer may be preconfigured with data representing an inverse (transform) of a projection function that associates any number in the first range of (real) numbers with a corresponding number in the second range of (real) numbers, or may receive data representing such an inverse (transform) of a projection function (from the sender computer or a configuration server of the computing environment).

In some embodiments, determining (e.g. identifying) an inverse of the projection function $f$ that associates the first (real) number and the second (real) number may comprise determining (e.g. identifying) the projection function $f$ that associates the first (real) number and the second (real) number such as for example according to Eq. 2.

In one or more embodiments, the recipient computer may be configured to determine, based on the data representing the first (real) number r that carries the encoding of the second (real) number $\tilde{r}$ with no exponent field, the first (real) number r by reverse transforming the second (real) number $\tilde{r}$ using an inverse of a function that transforms (maps) numbers of the interval $[a,b]$ into numbers of the interval $[2^i, 2^{i+1}[$ ($i$ being a natural integer that may be preconfigured, or in some embodiments received as configuration data by the recipient computer) (which may indifferently be referred to herein as the "image interval" or the "image range"). For example, for $i = 0$, the image interval may be $[1, 2[$.

In one or more embodiments, the recipient computer may be configured to determine, based on the data representing the first (real) number $r$ that carries the encoding of the second (real) number $\tilde{r}$ with no exponent field, the first (real) number r by reverse transforming the second (real) number $\tilde{r}$ using an inverse of a function that transforms (maps) numbers of the interval $[a,b]$ into numbers of the interval $[2^i, 2^{i+1} - \varepsilon]$ ($i$ being a natural integer that may be preconfigured, or in some embodiments received as configuration data by the recipient computer, and $\varepsilon$ being a real such that $0 < \varepsilon < 2^{i+1} - 2^i$ that may be preconfigured, or in some embodiments received as configuration data by the recipient computer). In some embodiments in which the double binary format defined by the IEEE 754 standard is used, the value of the parameter $\varepsilon$ may be chosen to be based on (in some embodiments equal to) $(2^{i+1} - 2^i)/2^{52}$. For example, for $i = 0$, the image interval may be $[1, 2 - \varepsilon]$ and $\varepsilon$ may be chosen equal to $2^{-52}$.

In one or more embodiments, the second (real) number $\tilde{r}$ may be determined by the sender computer by performing operations comprising transforming the first (real) number r using a function that maps the interval $[a,b]$ into the interval $[2^i, 2^{i+1} - \varepsilon]$, wherein i is a natural integer that may be preconfigured, or in some embodiments received as configuration data by the recipient computer, and $\varepsilon$ being a real such that $0 < \varepsilon < 2^{i+1} - 2^i$ that may be preconfigured, or in some embodiments received as configuration data by the recipient computer, and wherein a is a lower bound value of the first range of (real) numbers, and b is an upper bound value $b$ of the first range of (real) numbers, such that $a < b$, wherein the bound values $a$ and $b$ may be preconfigured, or in some embodiments received as configuration data by the recipient computer.

For example, in some embodiments, the second (real) number $\tilde{r}$ may be determined by the sender computer by performing operations comprising transforming the first (real) number r using a function that transforms (maps) the interval $[a,b]$ into the interval $[1, 2 - \varepsilon]$ ($i = 0$, and $0 < \varepsilon < 1$), such as for example the function $f$ defined by Eq. 2, wherein $a$ is a lower bound value of the first range of (real) numbers, and $b$ is an upper bound value $b$ of the first range of (real) numbers, such that $a < b$.

In one or more embodiments, the second (real) number $\tilde{r}$ may be determined by transforming the first (real) number $r \in [a,b]$ using the following (projection) function $f$:

$$\tilde{r} := f(r) = \frac{1-\varepsilon}{b-a}r + \left(1 - \frac{1-\varepsilon}{b-a}r\right)$$

wherein $0 < \varepsilon < 1$, *a* is a lower bound value of the first range of numbers, and *b* is an upper bound value of the first range of numbers, such that *a* < *b*. The function *f* advantageously operates to project the range (interval) [*a,b*] (first range of numbers) onto the range (interval) [1,2 - $\varepsilon$] (second range of numbers) ($\varepsilon$ being in some embodiments chosen such that $0 < \varepsilon < 1$, for example a negative power of 2), thereby generating a second (real) number $\tilde{r} \in [1,2 - \varepsilon]$ based on a first (real) number r $\in$ [*a,b*]. In some embodiments, $\varepsilon$ may be chosen equal to $2^{-52}$.

Correspondingly, in one or more embodiments, the first (real) number may be determined by the recipient computer based on the second (real) number $\tilde{r}$ by performing operations comprising reverse transforming the second (real) number $\tilde{r}$ using a (functional) inverse function denoted $f^{-1}$ of a function *f* that transforms (maps) the interval [*a,b*] into the interval [$2^i$, $2^{i+1}$ - $\varepsilon$] wherein i is a natural integer that may be preconfigured, or in some embodiments received as configuration data by the recipient computer, and $\varepsilon$ being a real such that $0 < \varepsilon < 2^{i+1} - 2^i$ that may be preconfigured, or in some embodiments received as configuration data by the recipient computer, and wherein *a* is a lower bound value of the first range of (real) numbers, and *b* is an upper bound value *b* of the first range of (real) numbers, such that *a* < *b,* wherein the bound values *a* and *b* may be preconfigured, or in some embodiments received as configuration data by the recipient computer. In some embodiments in which the double binary format defined by the IEEE 754 standard is used, the value of the parameter $\varepsilon$ may be chosen to be based on (in some embodiments equal to) $(2^{i+1} - 2^i)/2^{52}$. For example, for *i* = 0, the image interval may be [1,2 - $\varepsilon$] and $\varepsilon$ may be chosen equal to $2^{-52}$.

For example, in some embodiments, the first (real) number may be determined by the recipient computer by performing operations comprising reverse transforming the second (real) number $\tilde{r}$ using a (functional) inverse function denoted $f^{-1}$ of a function *f* that transforms (maps) the interval [*a,b*] into the interval [1,2 - $\varepsilon$] *(i* = 0, and $0 < \varepsilon < 1$), such as for example the function *f* defined by Eq. 2, wherein *a* is a lower bound value of the first range of (real) numbers, and *b* is an upper bound value of the first range of (real) numbers, such that *a* < *b.*

In one or more embodiments, the first (real) number *r* may be determined by reverse transforming the second (real) number $\tilde{r}$ using a (functional) inverse function of the following (projection) function *f:*

$$\tilde{r} := f(r) = \frac{1-\varepsilon}{b-a}r + \left(1 - \frac{1-\varepsilon}{b-a}r\right)$$

wherein $0 < \varepsilon < 1$, *a* is a lower bound value of the first range of numbers, and *b* is an upper bound value of the first range of numbers, such that *a* < *b.*

In one or more embodiments, the second range (interval) may be an interval of the type (that may be expressed as) [$2^i$, $2^{i+1}$[, where i is a natural integer or of the type (that may be expressed as) [$2^i$,$2^{i+1}$- $\varepsilon$], where $0 < \varepsilon < 2^{i+1} - 2^i$.

In one or more embodiments, the first (real) number *r* may be determined by reverse transforming the second (real) number $\tilde{r}$ using a (functional) inverse function of the exemplary (projection) function *f* of Eq. 2'.

In one or more embodiments, the format may be a double precision binary floating-point format for encoding floating-point numbers, such as according to the IEEE 754 standard.

In one or more embodiments, the sender computer may transmit to the recipient computer the data representing the first (real) number which carries an encoding of the second (real) number according to the format with no exponent field and no sign bit field corresponding to the encoded second (real) number. Correspondingly, in one or more embodiments, the recipient computer may receive from the sender computer the data representing the first (real) number which carries an encoding of the second (real) number according to the format with no exponent field and no sign bit field corresponding to the encoded second (real) number. Avoiding transmission of a sign bit field may further contribute to reduce the amount of data transmitted from the sender computer to the recipient computer, while still allowing the recipient computer to reconstruct the first (real) number based on received data that represents an encoding of the second (real) number according to a sign bit field/exponent field/mantissa field format with no exponent field and no sign bit field corresponding to the encoded second (real) number. With respect to the lack of sign bit field in the received data for the first (real) number, the recipient computer may be configured to assume that the received data relates to a positive number or, depending on the embodiment, to a negative number.

The following describes a proposed method in a distributed computing environment according to embodiments of the present subject disclosure.

In one or more embodiments, given a first (real) number *r* to transmit from a sender computer to a recipient computer of the distributed computing environment (for example given a double precision real value *r*), the sender computer may calculate a second (real) number $\tilde{r}$ based on *f(r)*, using a transform *f* that projects numbers of the interval [*a,b*] onto numbers of the interval [$2^i$,$2^{i+1}$[ (such as for example the transform *f* of Eq. 2).

Further, the sender computer may encode the second (real) number according to a (e.g. double precision binary floating-point) format comprising a sign bit field, an exponent bit field and a mantissa bit field, such as for example a double precision binary floating-point format according to the IEEE 754 standard. In some embodiments, the sender computer may extract the mantissa bits from the bitfields representing the double precision encoding of the second (real) number and may transmit these mantissa bits for transmitting the first (real) number to a recipient computer.

At the recipient computer side, the recipient computer may receive the mantissa bits from the sender computer. In some embodiments, based on the received mantissa bits, the recipient computer may rebuild the double precision encoding of the second (real) number. For example, in embodiments in which the recipient computer receives mantissa bits and a sign bit for the encoded second (real) number with no exponent field, the recipient computer may be configured to obtain (in some embodiments generate) an exponent field for the encoded second (real) number, and concatenate the received sign bit, the obtained exponent field and the received mantissa bits to generate a complete encoding of the second (real) number. As another example, in embodiments in which the recipient computer receives only mantissa bits for the encoding (with no sign bit and no exponent field) for the encoded second (real) number, the recipient computer may be configured to obtain (in some embodiments generate) an exponent field for the encoded second (real) number, to obtain (in some embodiments generate) a sign bit for the encoded second (real) number, and concatenate the obtained sign bit, the obtained exponent field and the received mantissa bits to generate a complete encoding of the second (real) number.

In one or more embodiments, the recipient computer may be configured to determine (calculate, compute) the first (real) number based on the complete encoding of the second (real) number, for example using a reverse transform of the transform $f$ used by the sender encoder (e.g. $r = f^{-1}(\tilde{r})$).

*Optimized mantissa bits packaging*

In one or more embodiments, the proposed scheme may be enhanced to avoid negating the performance gains achieved through reduced communication. For example, one or more aspects of the proposed scheme related to mantissa extraction and (first (real) number) value reconstruction may be enhanced for improved efficiency.

In one or more embodiments, a predetermined number of mantissa bits of the second (real) number may be retained for the transmission of the first (floating-point) number.

In some embodiments, extraction of the mantissa from the encoding of the second (real) number according to a binary format for encoding floating-point numbers may be performed in packets of bits. In some embodiments, these bit packets may be stored as simple data types, such as 64-bits, 32-bits, 16-bits or 8-bits integers, thereby minimizing the number of operations. In some embodiments, the second (real) number may be interpreted as a 64-bits integer, and one or more masks and bit offsets may be applied to this 64-bits integer in order to extract and recombine the mantissa bits for transmission to the recipient computer. Using bit packets to generate the mantissa bits that are transmitted to the recipient computer may advantageously allow vectorization by a compiler.

In one or more embodiments, the bit packets may be generated as follows:
A memory area (e.g. of the sender computer) storing real values to be encoded (and transmitted to the recipient computer) may be denoted by "d", and the k-th stored value may be denoted by d(k). Further, the extracted mantissa bits of the real floating-point value d(k) from the i-th to the j-th bit is denoted $d(k)\,|[i,j]$.

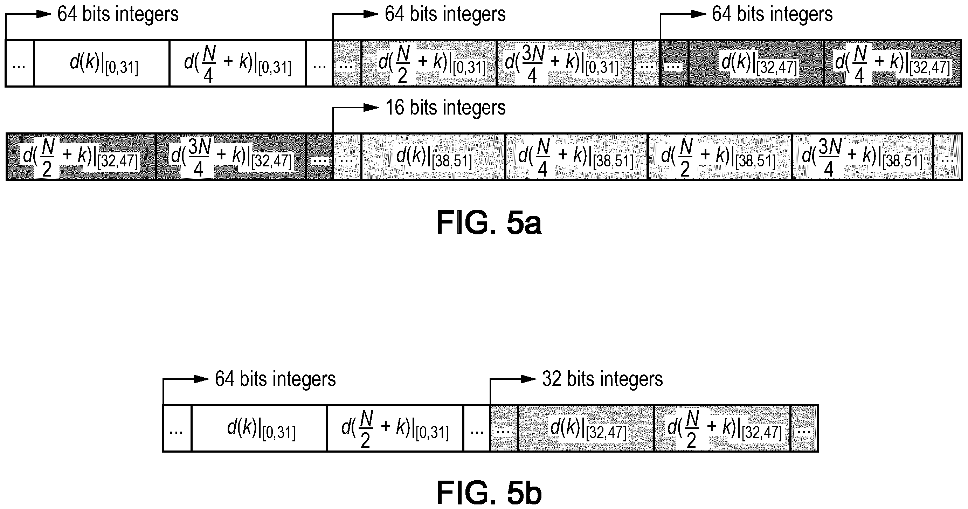

Figs. 5a - 5d illustrate different bits packaging of a mantissa according to one or more embodiments.

Figs. 5a - 5d show the bits packaging for different numbers of retained mantissa bits according to embodiments of the present subject disclosure, where N is the total number of values to encode:

Fig. 5a shows an exemplary 52 bits packaging (encoding per 4-uplet): For k = 1, ..., N/4, the mantissa bits buffer may be structured as illustrated by Fig. 5a.
Fig. 5b shows an exemplary 48 bits packaging (encoding per 2-uplet): For k = 1, ..., N/2, the mantissa bits buffer may be structured as illustrated by Fig. 5b.

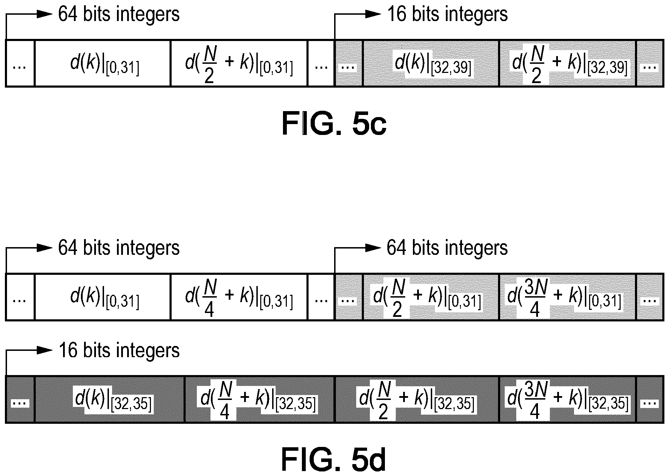

Fig. 5c shows an exemplary 40 bits packaging (encoding per 2-uplet): For k = 1, ..., N/2, the mantissa bits buffer may be structured as illustrated by Fig. 5c.
Fig. 5d shows an exemplary 36 bits packaging (encoding per 4-uplet): For k = 1, ..., N/4, the mantissa bits buffer may be structured as illustrated by Fig. 5d.

*Precision of the decoded values*

In the following, the precision of the reconstructed first (real) number (floating-point value) is discussed for the exemplary different numbers of transmitted mantissa bits discussed above according to one or more embodiments.

In embodiments in which the second (real) number value is stored in a binary format for encoding floating-point numbers according to the IEEE 754 standard, the value $\tilde{r}_s$ stored in memory may be an approximation of the exact value $\tilde{r}$, in some embodiments according to the following inequation:

$$|\tilde{r} - \tilde{r}_s| \le \varepsilon$$

$$\text{with } \varepsilon = 2^{-52}.$$

[Eq. 3]

In one or more embodiments, noting N the number of communicated mantissa bits and $\tilde{r}_s^N$ the value corresponding to $\tilde{r}_s$, keeping the N-th first significand bits, the error due to the abandoned bits (noted $\varepsilon_N$) may be written as:

$$\varepsilon_N := \max\{|\tilde{r} - \tilde{r}_s^N|\} = \sum_{i=N+1}^{52} 2^{-i}$$

[Eq. 4]

We have:

$$|\tilde{r} - \tilde{r}_s^N| \le |\tilde{r} - \tilde{r}_s| + |\tilde{r}_s - \tilde{r}_s^N| \le \varepsilon + \varepsilon_N$$

[Eq. 5]

Noting $r_s^N = f^{-1}(\tilde{r}_s^N)$ the value replaced in the initial range after its mantissa transmission, we have (r denoting the first (real) number transmitted to the recipient computer, r ∈ [a,b], [a,b] being the initial range of values (first range (interval) of numbers)):

$$|r - r_s^N| \le (\varepsilon + \varepsilon_N)\frac{b - a}{1 - \varepsilon}$$

[Eq. 6]

In embodiments in which the initial range of values (first range (interval) of numbers) is [-1,1], the precisions obtained for different bit packaging of the mantissa bits are as follows:

| Format | Precision |
|---|---|
| Double-precision floating-point | $2.22 \times 10^{-16}$ |
| 52 bits mantissa | $4.44 \times 10^{-16}$ |
| 48 bits mantissa | $6.66 \times 10^{-15}$ |
| 40 bits mantissa | $1.82 \times 10^{-12}$ |
| 36 bits mantissa | $2.91 \times 10^{-11}$ |

*Benchmarks*

In the following description of benchmarks, we compare the run time of QAOA Max Cut circuits that are simulated with the different number of mantissa bits retained as described above in some embodiments. The graphs that represent the Max Cut circuits are generated randomly, with an edge density of 0.1 to control the number of operations in the circuit.

The benchmarking is done in a distributed environment with 16 compute nodes, each consisting of 2 AMD Milan 7763 processors and 64 cores on each socket. Each node is equipped with 256 GB of RAM : 16 x 16GB DDR4-3200 Dual Rank, which means that the maximal number of qubits that can be simulated in double precision on a single node is 33 qubits (34 qubits will need 256GB of memory which hits the limit).

The nodes are interconnected by an Infiniband HDR100 interconnect.

The metrics that have been measured for these benchmarks are defined as follows:

- Total data transmission time (time used for data transmission): Data transmission time (time used for (duration of) data transmission): Averages of the processes' data transmission time (time used for (duration of) data transmission) including processes waiting time and mantissa encoding/decoding time,
- Simulation time: The total elapsed time,
- Performance gain: Ratio between the time gain and the reference time.

All times are given in seconds and are averages of 10 runs.

Benchmark results for simulation of a 34 qubits circuit on 2 processes:

| Format | Total communication time | Simulation time | Performance gain |
|---|---|---|---|
| Double-precision floating-point | 45.77 | 144.76 | - |
| 52 bits mantissa | 27.09 | 125.69 | 13.2% |
| 48 bits mantissa | 25.55 | 121.81 | 15.9% |
| 40 bits mantissa | 22.74 | 118.41 | 18.2% |
| 36 bits mantissa | 22.96 | 117.98 | 18.5% |

Benchmark results for simulation of a 35 qubits circuit on 4 processes:

| Format | Total communication time | Simulation time | Performance gain |
|---|---|---|---|
| Double-precision floating-point | 104.86 | 210.48 | - |
| 52 bits mantissa | 86.51 | 191.77 | 8.9% |
| 48 bits mantissa | 82.46 | 187.75 | 10.8% |
| 40 bits mantissa | 78.25 | 183.95 | 12.6% |
| 36 bits mantissa | 75.12 | 180.63 | 14.2% |

Benchmark results for simulation of a 36 qubits circuit on 8 processes:

| Format | Total communication time | Simulation time | Performance gain |
|---|---|---|---|
| Double-precision floating-point | 148.64 | 255.93 | - |
| 52 bits mantissa | 122.49 | 234.57 | 8.3% |
| 48 bits mantissa | 112.48 | 220.82 | 13.7% |
| 40 bits mantissa | 103.72 | 213.57 | 16.5% |
| 36 bits mantissa | 101.46 | 210.66 | 17.7% |

Benchmark results for simulation of a 37 qubits circuit on 16 processes:

| Format | Total communication time | Simulation time | Performance gain |
|---|---|---|---|
| Double-precision floating-point | 195.89 | 312 | - |
| 52 bits mantissa | 158.06 | 276.44 | 11.4% |
| 48 bits mantissa | 151.21 | 269.17 | 13.7% |
| 40 bits mantissa | 139.26 | 256.18 | 17.9% |

| 36 bits mantissa | 136.43 | 254.2 | 18.5% |
|---|---|---|---|

The above charts show a performance gain in the data transmission time criterion, which improves as fewer mantissa bits are encoded. This improvement can be attributed to the reduction in the size of the transmitted data. Even after accounting for the overhead introduced by mantissa encoding and reconstruction, a performance gain of approximately 10 - 20% is still achieved.

_Use_ case: _Precision-aware distributed quantum circuit simulation_

In the particular use case of quantum circuit simulation, representing the complex amplitudes using double-precision floating-point format provides far more precision than necessary to achieve the simulation's objectives. By leveraging the fact that the performance gain from mantissa encoding increases as the number of encoded mantissa bits is reduced, the number of encoded mantissa bits can advantageously be adjusted in some embodiments based on the required precision of the simulation. In some embodiments, a user may be able to input the desired precision for the simulation, and the number of mantissa bits required to obtain this precision may be automatically determined based on the user input.

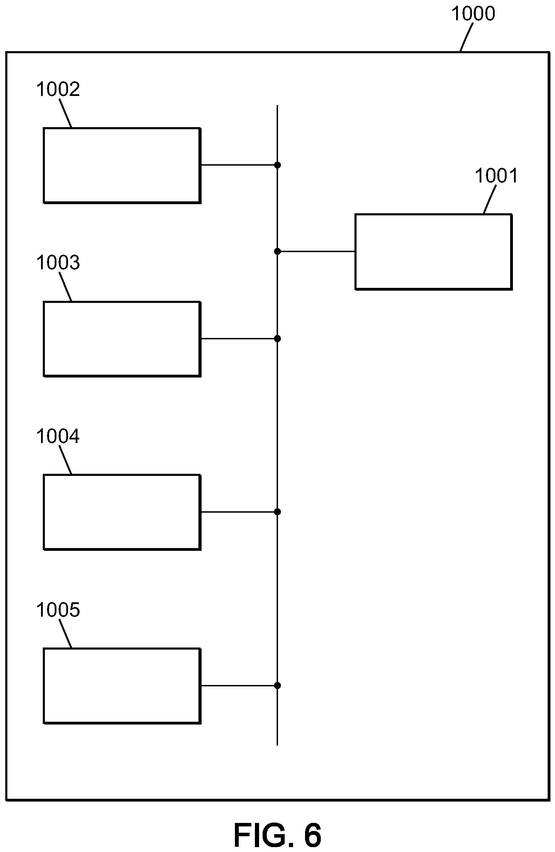

Fig. 6 illustrates an exemplary apparatus 1000 configured to use one or more of a data transmission feature and a data reception feature in accordance with embodiments of the present subject disclosure. The apparatus 1000 may, depending on the embodiment, be comprised in a HPC cluster, an electronic circuit, an electronic board, an electronic component, chip, a QPU, a CPU, or any other suitable processing platform.

The apparatus 1000, which may comprise one or more computers, includes a control engine 1001, a number encoding engine 1002, a computing engine 1003, a data communication engine 1004, and a memory 1005.

In the architecture illustrated on Fig. 6, all of the number encoding engine 1002, computing engine 1003, data communication engine 1004, and memory 1005 are operatively coupled with one another through the control engine 1001.

In one or more embodiments, the number encoding engine 1002 may be configured to perform various functions or embodiments provided in the present subject disclosure, including with respect to determining an encoding of the second (real) number according to a binary format for encoding floating-point numbers, wherein a binary code representing a number encoded according to the format comprises a sign binary field carrying at most one sign bit encoding a sign of the number, an exponent binary field carrying one or more exponent bits encoding an exponent of a power of 2, and a fraction binary field carrying one or more significant decimal digits. In one or more embodiments, the number encoding engine 1002 may be configured to perform various functions or embodiments provided in the present subject disclosure, including with respect to generating, based on received data, a binary code corresponding to the second (real) number encoded according to the format, the binary code corresponding to the encoded second (real) number comprising a respective exponent binary field, a respective sign binary field, and a respective fraction binary field, and determining, based on the binary code corresponding to the encoded second (real) number, a first (real) number. In some embodiments, the number encoding engine 1002 may be implemented in software and incorporated in a computing machine configured according to embodiments of the present subject disclosure.

In one or more embodiments, the computing engine 1003 may be configured with one or more classical processing resources (e.g. one or more CPUs) and one or more quantum processing resources (e.g. one or more QPUs) to perform various functions or embodiments provided in the present subject disclosure, including with respect to obtaining a second (real) number $\tilde{r}$ corresponding to the first (real) number, where the first (real) number belongs to a first range of numbers, and the second (real) number belongs to a second range of numbers.

In one or more embodiments, the data communication engine 1004 may be configured to provide a data interface to the apparatus 1000, including for exchanging data with another apparatus, including with respect to one or more of transmitting, to a recipient computing machine, data representing a first (real) number, where the data carries an encoding of the second (real) number according to the format with no exponent field corresponding to the encoded second (real) number, and receiving, from a sender computing machine, data representing the first (real) number, wherein the data carries an encoding of a second (real) number according to a format with no exponent field corresponding to the encoded second (real) number, where a binary code representing a number encoded according to the format comprises a sign binary field carrying zero or one sign bit encoding a sign of the number, an exponent binary field carrying one or more exponent bits encoding an exponent of a power of 2, and a fraction binary field carrying one or more significant decimal digits.

The control engine 1001 includes a processor, which may be any suitable microprocessor, microcontroller, Field Programmable Gate Arrays (FPGA), Application Specific Integrated Circuits (ASIC), Digital Signal Processing chip, and/or state machine, or a combination thereof. According to various embodiments, one or more of the computers can be configured as a multi-processor computer having multiple processors for providing parallel computing. The control engine 1001 may also comprise, or may be in communication with, computer storage media, such as, without limitation, the memory 1005, capable of storing computer program instructions or software code that, when executed by the processor, causes the processor to perform the elements described herein. In addition, the memory 1005 may be any type of data storage computer storage medium, capable of storing multimedia content data, service data, service list data, customization data, personalization data and/or channel data for use according to one or more embodiments of the present subject disclosure, coupled to the control engine 1001 and operable with the data communication engine 1004, the computing engine 1003, and the number encoding engine 1002 to facilitate processing of data stored in association therewith.

In embodiments of the present subject disclosure, the apparatus 1000 is configured for performing one or more of the methods described herein.

It will be appreciated that the apparatus 1000 shown and described with reference to Fig. 6 is provided by way of example only. Numerous other architectures, operating environments, and configurations are possible. Other embodiments of the apparatus may include fewer or greater number of components and may incorporate some or all of the functionality described with respect to the apparatus components shown in Fig. 6. Accordingly, although the control engine 1001, data communication engine 1004, computing engine 1003, number encoding engine 1002, and memory 1005 are illustrated as part of the apparatus 1000, no restrictions are placed on the location and control of components 1001 - 1005. In particular, in other embodiments, components 1001 - 1005 may be part of different entities or computing systems.

Although this subject disclosure has been disclosed in the context of certain preferred embodiments, it should be understood that certain advantages, features and aspects of the systems, devices, and methods may be realized in a variety of other embodiments. Additionally, it is contemplated that various aspects and features described herein can be practiced separately, combined together, or substituted for one another, and that a variety of combination and sub-combinations of the features and aspects can be made and still fall within the scope of the subject disclosure. Furthermore, the systems and devices described above need not include all of the modules and functions described in the preferred embodiments.

Information and signals described herein can be represented using any of a variety of different technologies and techniques. For example, data, instructions, commands, information, signals, bits, symbols, and chips can be represented by voltages, currents, electromagnetic waves, magnetic fields or particles, optical fields or particles, or any combination thereof.

Depending on the embodiment, certain acts, events, or functions of any of the methods described herein can be performed in a different sequence, may be added, merged, or left out all together (e.g., not all described acts or events are necessary for the practice of the method). Moreover, in certain embodiments, acts or events may be performed concurrently rather than sequentially.

**Claims**

1. A method for transmitting a first number r to a recipient computing machine in a distributed computing environment, the method comprising, by a sender computing machine in the distributed computing environment:

   obtaining a second number $\bar{r}$ corresponding to the first number, wherein the first number belongs to a first range of numbers, and the second number belongs to a second range of numbers;
   determining an encoding of the second number according to a binary format for encoding floating-point numbers, wherein a binary code representing a number encoded according to the format comprises a sign binary field carrying at most one sign bit encoding a sign of the number, an exponent binary field carrying one or more exponent bits encoding an exponent of a power of 2, and a fraction binary field carrying one or more significant decimal digits; and
   transmitting, to the recipient computing machine, data representing the first number, wherein the data carries an encoding of the second number according to the format with no exponent field corresponding to the encoded second number.

2. The method according to claim 1, further comprising: transmitting, to the recipient computing machine, one or more of data representing the second range of numbers and data representing the first range of numbers.

3. The method according to any of the preceding claims, wherein the second number $\bar{r}$ is determined by transforming the first number r using a function that transforms the interval $[a,b]$ into the interval $[2^i, 2^{i+1}[$, wherein i is a natural integer, wherein $a$ is a lower bound value of the first range of numbers, and b is an upper bound value of the first range of numbers, such that $a < b$.

4. The method according to any of the preceding claims, wherein the second number $\bar{r}$ is determined by transforming the first number r using the following function $f$:

$$\tilde{r} := f(r) = \frac{2^i - \varepsilon}{b - a} r + \left( 2^i - \frac{2^i - \varepsilon}{b - a} a \right)$$

wherein $\varepsilon$ is a real number such that $0 < \varepsilon < 2^{i+1} - 2^i$, $i$ is a natural integer, $a$ is a lower bound value of the first range of numbers, and b is an upper bound value of the first range of numbers, such that $a < b$.

5. A method for receiving a first number from a first computing machine in a distributed computing environment, the method comprising, by a second computing machine in the distributed computing environment:

   receiving, from the sender computing machine, data representing the first number, wherein the data carries an encoding of a second number according to a format with no exponent field corresponding to the encoded second number, wherein a binary code representing a number encoded according to the format comprises a sign binary field carrying zero or one sign bit encoding a sign of the number, an exponent binary field carrying one or more exponent bits encoding an exponent of a power of 2, and a fraction binary field carrying one or more significant decimal digits;
   generating, based on the received data, a binary code corresponding to the second number encoded according to the format, the binary code corresponding to the encoded second number comprising a respective exponent binary field, a respective sign binary field, and a respective fraction binary field; and
   determining, based on the binary code corresponding to the encoded second number, the first number.

6. The method according to claim 5, wherein the first number belongs to a first range of numbers, and the second number belongs to a second range of numbers different from the first range of numbers.

7. The method according to claim 6, further comprising: receiving, from the sender computing machine, one or more of: data representing the first range of numbers, and data representing the second range of numbers.

8. The method according to any of claims 5 - 7, wherein the first number belongs to a first range of numbers $[a,b]$, and the second number belongs to a second range of numbers $[2^i,2^{i+1}[$, wherein i is a natural integer, the method further comprising: obtaining data representing the second range of numbers, wherein the first number r is determined by reverse transforming the second number $\tilde{r}$ using an inverse of a function that transforms numbers of the interval $[a,b]$ into numbers of the interval $[2^i,2^{i+1}[$.

9. The method according to any of claims 5 - 8, wherein the first number belongs to a first range of numbers, and the second number belongs to a second range of numbers, wherein the first number r is determined by reverse transforming the second number $\tilde{r}$ using an inverse of the following function $f$:

$$\tilde{r} := f(r) = \frac{2^i - \varepsilon}{b - a} r + \left( 2^i - \frac{2^i - \varepsilon}{b - a} a \right)$$

wherein $\varepsilon$ is a real number such that $0 < \varepsilon < 2^{i+1} - 2^i$, $i$ is a natural integer, $a$ is a lower bound value of the first range of numbers, and b is an upper bound value of the first range of numbers, such that $a < b$.

10. The method according to any of the preceding claims, wherein the data carries the encoding of the second number according to the format with no sign field corresponding to the encoded second number.

11. The method according to any of the preceding claims, wherein the second range is an interval expressible as $[2^i,2^{i+1} - \varepsilon]$, where $0 < \varepsilon < 2^{i+1} - 2^i$, and i is a natural integer, and wherein the value of the real $\varepsilon$ is based on a distance between the lower bound $2^i$ and the next value representable by the format for encoding floating-point numbers.

12. The method according to any of the preceding claims, wherein the format is a double precision binary floating-point format for encoding floating-point numbers.

13. The method according to any of the preceding claims, wherein the format is according to the IEEE 754 standard.

14. An apparatus, the apparatus comprising a processor and a memory operatively coupled to the processor, wherein the

**EP 4 764 819 A1**

apparatus is configured to perform a method according to any of claims 1 to 13.

15. A computer program product comprising computer program code embodied in a computer readable medium, said computer program code comprising instructions to, when provided to a computer system and executed, cause said computer to perform a method according to any of claims 1 to 13.

22

FIG. 1a

a) Communication between pairs of MPI processes with initial state vector

b) Local application of the quantum gate

c) Communication between pairs of MPI processes to initial placement

d) Final state vector

**FIG. 2**

sign  exponent (11 bit)  fraction (52 bit)

63  52  0

**FIG. 3**

**101**

obtaining a second number corresponding to the first number, wherein the first number belongs to a first range of numbers, and the second number belongs to a second range of numbers

**102**

determining an encoding of the second number according to a binary format for encoding floating-point numbers, wherein a binary code representing a number encoded according to the format comprises a sign binary field carrying at most one sign bits encoding a sign of the number, an exponent binary field carrying one or more exponent bits encoding an exponent of a power of 2, and a fraction binary field carrying one or more significant decimal digits

**103**

transmitting, to the recipient computing machine, data representing the first number, wherein the data carries an encoding of the second number according to the format with no exponent field corresponding to the encoded second number

**100**

# FIG. 4a

201

receiving, from a sender computing machine, data representing the first number, wherein the data carries an encoding of a second number according to a format with no exponent field corresponding to the encoded second number, wherein a binary code representing a number encoded according to the format comprises a sign binary field carrying zero or one sign bit encoding a sign of the number, an exponent binary field carrying one or more exponent bits encoding an exponent of a power of 2, and a fraction binary field carrying one or more significant decimal digits

202

generating, based on the received data, a binary code corresponding to the second number encoded according to the format, the binary code corresponding to the encoded second number comprising a respective exponent binary field, a respective sign binary field, and a respective fraction binary field

203

determining, based on the binary code corresponding to the encoded second number, the first number

200

# FIG. 4b

64 bits integers      64 bits integers      64 bits integers

| ... | $d(k)\vert_{[0,31]}$ | $d(\frac{N}{4}+k)\vert_{[0,31]}$ | ... | ... | $d(\frac{N}{2}+k)\vert_{[0,31]}$ | $d(\frac{3N}{4}+k)\vert_{[0,31]}$ | ... | ... | $d(k)\vert_{[32,47]}$ | $d(\frac{N}{4}+k)\vert_{[32,47]}$ |

16 bits integers

| $d(\frac{N}{2}+k)\vert_{[32,47]}$ | $d(\frac{3N}{4}+k)\vert_{[32,47]}$ | ... | ... | $d(k)\vert_{[38,51]}$ | $d(\frac{N}{4}+k)\vert_{[38,51]}$ | $d(\frac{N}{2}+k)\vert_{[38,51]}$ | $d(\frac{3N}{4}+k)\vert_{[38,51]}$ | ... |

## FIG. 5a

64 bits integers      32 bits integers

| ... | $d(k)\vert_{[0,31]}$ | $d(\frac{N}{2}+k)\vert_{[0,31]}$ | ... | ... | $d(k)\vert_{[32,47]}$ | $d(\frac{N}{2}+k)\vert_{[32,47]}$ | ... |

## FIG. 5b

27

EP 4 764 819 A1

64 bits integers       16 bits integers

| ... | $d(k)|_{[0,31]}$ | $d(\frac{N}{2} + k)|_{[0,31]}$ | ... | ... | $d(k)|_{[32,39]}$ | $d(\frac{N}{2} + k)|_{[32,39]}$ | ... |

## FIG. 5c

64 bits integers       64 bits integers

| ... | $d(k)|_{[0,31]}$ | $d(\frac{N}{4} + k)|_{[0,31]}$ | ... | ... | $d(\frac{N}{2} + k)|_{[0,31]}$ | $d(\frac{3N}{4} + k)|_{[0,31]}$ | ... |

16 bits integers

| ... | $d(k)|_{[32,35]}$ | $d(\frac{N}{4} + k)|_{[32,35]}$ | $d(\frac{N}{2} + k)|_{[32,35]}$ | $d(\frac{3N}{4} + k)|_{[32,35]}$ | ... |

## FIG. 5d

FIG. 6

**EUROPEAN SEARCH REPORT**

Application Number

EP 24 30 7179

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2017/250704 A1 (PIIRAINEN OLLI JUHANI [FI]) 31 August 2017 (2017-08-31)<br>* figures 1, 2, 3B *<br>* paragraph [0018] - paragraph [0044] *<br>* paragraph [0057] - paragraph [0063] *<br>----- | 1-15 | INV.<br>G06F7/483<br>H03M7/24 |
| X | US 2013/262539 A1 (WEGENER ALBERT W [US]) 3 October 2013 (2013-10-03)<br>* figures 7-9, 11, 20, 21, 25 *<br>* paragraph [0058] - paragraph [0096] *<br>* paragraph [0105] - paragraph [0106] *<br>* paragraph [0119] - paragraph [0131] *<br>----- | 1,5,14, 15 | |

**TECHNICAL FIELDS SEARCHED (IPC)**

G06F
H03M

The present search report has been drawn up for all claims

| Place of search | Date of completion of the search | Examiner |
|---|---|---|
| Munich | 30 May 2025 | Winkelbauer, Andreas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

............................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 30 7179

This annex lists the patent family members relating to the patent documents cited in the above-mentioned European search report.
The members are as contained in the European Patent Office EDP file on
The European Patent Office is in no way liable for these particulars which are merely given for the purpose of information.

30-05-2025

| Patent document cited in search report | | Publication date | Patent family member(s) | | Publication date |
|---|---|---|---|---|---|
| US 2017250704 | A1 | 31-08-2017 | EP | 3198727 A1 | 02-08-2017 |
| | | | US | 2017250704 A1 | 31-08-2017 |
| | | | WO | 2016045733 A1 | 31-03-2016 |
| US 2013262539 | A1 | 03-10-2013 | US | 2013262539 A1 | 03-10-2013 |
| | | | WO | 2013149050 A1 | 03-10-2013 |

EPO FORM P0459

For more details about this annex : see Official Journal of the European Patent Office, No. 12/82